# EUROPEAN PATENT APPLICATION

(11) **EP 1 968 366 A1**
(43) Date of publication of application: **10.09.2008**
(21) Application number: 06843328.3
(22) Date of filing: 26.12.2006
(51) Int. Cl.: H05K 3/34, B23K 1/00, B23K 3/04

(54) **SOLDERING METHOD, SEMICONDUCTOR MODULE MANUFACTURING METHOD AND SOLDERING APPARATUS**

(30) Priority: 28.12.2005 JP 2005380354
(71) Applicant: Kabushiki Kaisha Toyota Jidoshokki, Kariya-shi, Aichi 448-8671 (JP)
(72) Inventor: KIMBARA, Masahiko, Aichi 448-8671 (JP)
(74) Representative: TBK-Patent
(86) International application number: PCT/JP2006/325944
(87) International publication number: WO 2007/074835

(57) **Abstract**

A soldering method for soldering an electronic component onto a circuit board is provided. The soldering method uses a cooling circuit board as the circuit board. The cooling circuit board includes an insulation substrate and a metal heat sink. The insulation substrate has a front surface with a metal circuit and a rear surface to which the heat sink is fixed. The heat sink has a refrigerant passage. The electronic component is arranged on the metal circuit with solder in between. A heated heating medium is supplied to the refrigerant passage when heating and melting the solder.

## Description

### TECHNICAL FIELD

The present invention relates to a soldering method, a semiconductor module manufacturing method, and a soldering apparatus.

### BACKGROUND ART

When mounting electronic components, such as semiconductor elements, chip resistors, and chip capacitors, on a circuit board, the electronic components are normally bonded to the circuit board with solder. As a method for melting solder when performing soldering, patent document 1 discloses a method that melts solder when a circuit board on which electronic components are mounted by means of solder is conveyed in a reflow furnace. Patent document 2 discloses a method that melts solder by performing high frequency induction heating.

In patent document 1, a soldering apparatus includes a box-shaped carrier, which has an upper portion for holding the board on which the electronic components are mounted, a conveyance mechanism, which conveys the carrier, and a reflow furnace, which is arranged at a predetermined location of the conveyance mechanism. The outer part of the carrier is formed from a heat insulating material, and a heater is arranged in the carrier. The board is heated from above by a heater arranged in the reflow furnace and also heated from below by the heater in the carrier.

In the soldering method of patent document 2, solder is placed on a wired circuit of a board, and electronic components are arranged so that their electrodes contact the solder. Then, a holding plate for holding a heating body is arranged so that the electrodes are held between the solder and the heating body. Subsequently, induction heating coils perform induction heating on the heating body so that the heat conduction from the heating body to the solder melts the solder.

Patent document 3 discloses a soldering apparatus in which semiconductor elements are arranged on a board by means of solder, and fluid heated to a temperature greater than or equal to the melting point of solder is supplied to the lower side of the board to melt the solder. The soldering apparatus of patent document 3 includes a container, which is sealable and enables inert gas or hydrogen gas to be charged therein. The soldering is carried out in the container.

The soldering apparatus of patent document 1 includes the heater that heats the board from the lower side in addition to the heating device (heater) arranged in a normal reflow furnace. Thus, the solder is efficiently heated in comparison to when using only the normal reflow furnace. However, the apparatus of patent document 1 heats the board from below. Thus, a special carrier incorporating the heater must be used. As a result, the conveyance mechanism must be provided with a special structure that is suitable for conveying the special carrier.

In the soldering method of patent document 2, the solder is heated by the heating body, which is heated through induction heating. Thus, in comparison to a soldering method using a normal reflow furnace, the solder is efficiently heated. To quickly heat the solder, the temperature of the heating body must be increased to shorten the time of heat conduction. However, if the temperature of the heating body is too high, damages may be inflicted on the semiconductor elements, which are electronic components.

In the soldering apparatus of patent document 3, heated fluid comes into direct contact with the board and heats the board from below. Thus, the solder is efficiently heated in comparison with a normal reflow furnace. However, the apparatus of patent document 3 requires a structure for contacting heated fluid with the board.
Patent Document 1: Japanese Laid-Open Patent Publication No. 2001-339152
Patent Document 2: Japanese Laid-Open Patent Publication No. 8-293668
Patent Document 3: Japanese Laid-Open Patent Publication No. 62-257737

### DISCLOSURE OF THE INVENTION

It is an object of the present invention to provide a novel soldering method, method for manufacturing a semiconductor module, and soldering apparatus that are for soldering electronic components onto a circuit board.

To achieve the above object, one aspect of the present invention provides a soldering method for soldering an electronic component onto a circuit board. The method includes using as the circuit board a cooling circuit board including an insulation substrate and a metal heat sink, with the insulation substrate having a front surface with a metal circuit and a rear surface to which the heat sink is fixed, and the heat sink having a refrigerant passage. The method further includes arranging the electronic component on the metal circuit with solder in between, and supplying a heated heating medium to the refrigerant passage when heating and melting the solder.

Another aspect of the present invention provides a soldering method for soldering an electronic component onto a circuit board. The method includes using as the circuit board a cooling circuit board including an insulation substrate and a metal heat sink, with the insulation substrate having a front surface with a metal circuit and a rear surface to which the heat sink is fixed, and the heat sink having a refrigerant passage. The method further includes arranging the electronic component on the metal circuit with solder in between, heating and melting the solder, and supplying a cooling medium to the refrigerant passage after stopping the heating of the solder to cool the cooling circuit board and solder.

A further aspect of the present invention provides a method for manufacturing a semiconductor module formed by soldering an electronic component onto a circuit board. The method includes using as the circuit board a cooling circuit board including an insulation substrate and a metal heat sink, with the insulation substrate having a front surface with a metal circuit and a rear surface to which the heat sink is fixed, and the heat sink having a refrigerant passage. The method further includes arranging the electronic component on the metal circuit with solder in between, and supplying a heated heating medium to the refrigerant passage when heating and melting the solder.

Still another aspect of the present invention is a method for manufacturing a semiconductor module formed by soldering an electronic component onto a circuit board. The method includes using as the circuit board a cooling circuit board including an insulation substrate and a metal heat sink, with the insulation substrate having a front surface with a metal circuit and a rear surface to which the heat sink is fixed, and the heat sink having a refrigerant passage. The method further includes arranging the electronic component on the metal circuit with solder in between;, heating and melting the solder, and supplying a cooling medium to the refrigerant passage after stopping the heating of the solder to cool the cooling circuit board and solder.

Yet another aspect of the present invention is a soldering apparatus for soldering an electronic component onto a circuit board. The soldering apparatus includes a support, a heating medium supply unit and a control unit. The support is capable of supporting the circuit board. The circuit board is a cooling circuit board including an insulation substrate and a metal heat sink. The insulation substrate has a front surface with a metal circuit and a rear surface to which the heat sink is fixed. The heat sink has a refrigerant passage. The refrigerant passage includes an inlet and an outlet. The heating medium supply unit is capable of supplying a heating medium to the refrigerant passage. The heating medium supply unit includes a pipe connectable to the inlet and the outlet in a state in which the cooling circuit board is supported by the support. The control unit controls temperature of the heating medium supplied to the refrigerant passage.

### BRIEF DESCRIPTION OF THE DRAWINGS

Fig. 1 is a plan view showing a semiconductor module according to a first embodiment of the present invention;
Fig. 2 is a cross-sectional view taken along line 2-2 of Fig 1;
Fig. 3 is a schematic cross-sectional view of a soldering apparatus according to the first embodiment;
Fig. 4 is a schematic diagram showing a heating medium supply unit and cooling medium supply unit connected to the soldering apparatus of Fig. 3;
Fig. 5(a) is a plan view showing a jig used for soldering;
Fig. 5(b) is a perspective view showing a weight used for soldering; and
Fig. 6 is a schematic cross-sectional view of a soldering apparatus according to a second embodiment of the present invention.

### BEST MODE FOR CARRYING OUT THE INVENTION

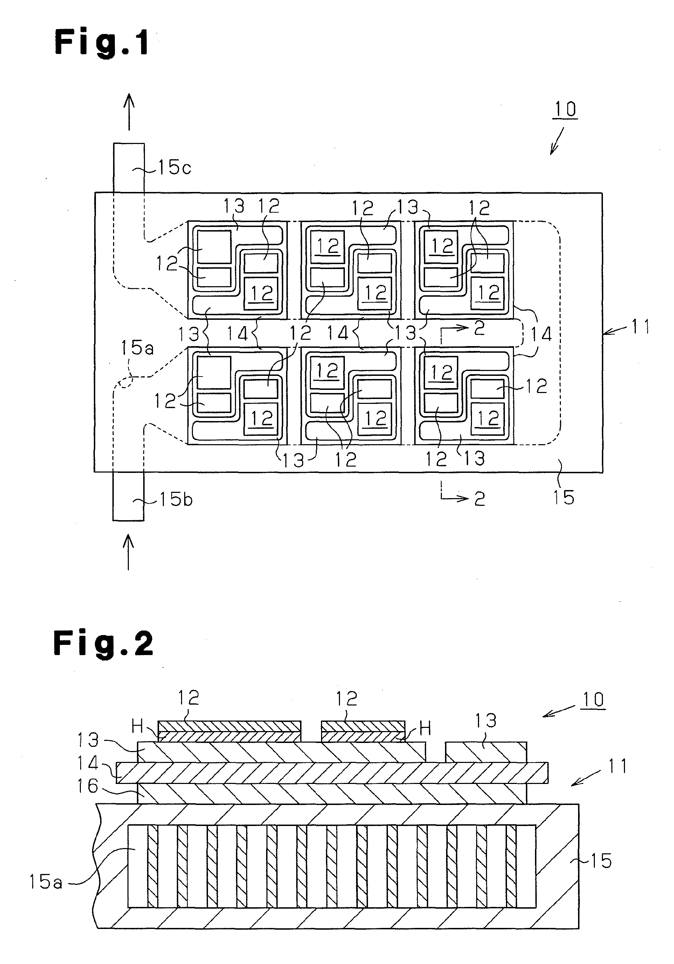

A first embodiment of the present invention will now be described with reference to Figs. 1 to 5.

As shown in Fig. 1, a semiconductor module (semiconductor device) 10 includes a circuit board 11 and a plurality of semiconductor elements 12, which serve as electronic components. The plurality of semiconductor elements 12 are soldered and bonded to the circuit board 11. The circuit board 11 includes a plurality of (six in the present embodiment) ceramic substrates 14, which serve as insulation substrate. Metal circuits 13 are arranged on the surface of each ceramic substrate 14. Four semiconductor elements 12 are soldered to each ceramic substrate 14. A total of twenty-four semiconductor elements 12 are laid out on the semiconductor module 10.

As shown in Fig. 2, the circuit board 11 includes the ceramic substrates 14 and a metal heat sink 15, which is fixed to the ceramic substrates 14 with a metal plate 16 arranged therebetween. That is, the circuit board 11 is a cooling circuit board. The heat sink 15 has a refrigerant passage 15a, through which refrigerant flows. As shown in Fig. 1, the refrigerant passage 15a includes an inlet 15b and an outlet 15c. The inlet 15b and the outlet 15c are formed to be connectable to a cooling medium circuit (for example, one installed in a vehicle). The heat sink 15 is formed from an aluminum metal, copper, or the like. An aluminum metal refers to aluminum or an aluminum alloy. The metal plate 16, which functions as a bonding layer for bonding the ceramic substrates 14 and the heat sink 15, is formed from, for example, aluminum or copper.

The metal circuits 13 are formed from, for example, aluminum, copper, or the like. The ceramic substrates 14 are formed from, for example, aluminum nitride, alumina, silicon nitride, or the like. The semiconductor elements 12 are bonded (soldered) to the metal circuits 13. More specifically, the metal circuits 13 serve as bonding portions for bonding the semiconductor elements 12 to the circuit board 11. In Fig. 2, character H indicates a soldering layer. The semiconductor elements 12 may be, for example, IGBTs (Insulated Gate Bipolar Transistors) or diodes.

A method for manufacturing the semiconductor module 10 will now be described.

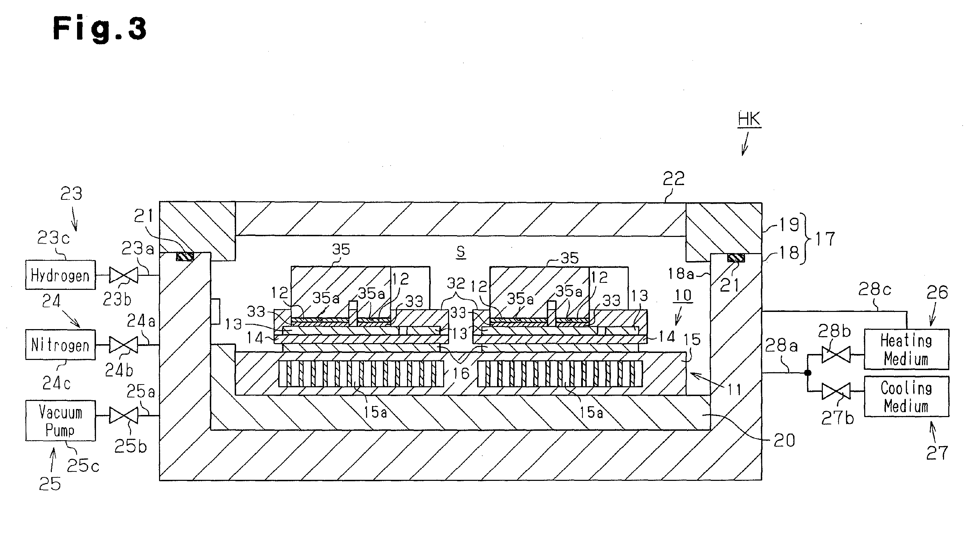

Fig. 3 schematically shows the structure of a soldering apparatus. The soldering apparatus HK is used to solder the semiconductor elements 12 to the metal circuits 13, which are arranged on the circuit board 11. Further, the soldering apparatus HK of this embodiment is used to solder the semiconductor elements 12 on the circuit board 11, which includes the plurality of (six) ceramic substrates 14 arranged on the heat sink 15.

The soldering apparatus HK includes a sealable container (chamber) 17. The container 17 includes a main body 18 and a cover body 19. The main body 18 is box-shaped and has an opening 18a. The cover body 19 opens and closes the opening 18a of the main body 18. A support base 20, which functions as a support for positioning and supporting the semiconductor module 10, is arranged on the main body 18. A packing 21, which comes into close contact with the cover body 19, is arranged in the open end of the main body 18. The cover body 19 is large enough to close the opening 18a of the main body 18. Attachment of the cover body 19 to the main body 18 defines a sealed space S in the container 17.

A reducing gas supply unit 23, which supplies reducing gas (hydrogen in this embodiment) into the container 17, is connected to the main body 18. The reducing gas supply unit 23 includes a pipe 23a, a valve 23b arranged in the pipe 23a, and a hydrogen tank 23c. An inert gas supply unit 24, which supplies inert gas (nitrogen in the present embodiment) into the container 17, is connected to the main body 18. The inert gas supply unit 24 includes a pipe 24a, a valve 24b arranged in the pipe 24a, and a nitrogen tank 24c. A gas discharge unit 25, which discharges gas filled in the container 17 to the outside, is connected to the main body 18. The gas discharge unit 25 includes a pipe 25a, a valve 25b arranged in the pipe 25a, and a vacuum pump 25c. The soldering apparatus HK is configured so that it can adjust the pressure in the sealed space S with the reducing gas supply unit 23, the inert gas supply unit 24, and the gas discharge unit 25. The pressure adjustment pressurizes or depressurizes the sealed space S. Electromagnetic valves are used as the valves 23b, 24b, and 25b.

A heating medium supplying unit 26, which supplies a heating medium heated in the refrigerant passage 15a of the circuit board 11 when heating the solder, is connected to the main body 18. Further, a cooling medium supplying unit 27, which supplies a cooling medium to the refrigerant passage 15a after stopping the heating of the solder, is connected to the main body 18.

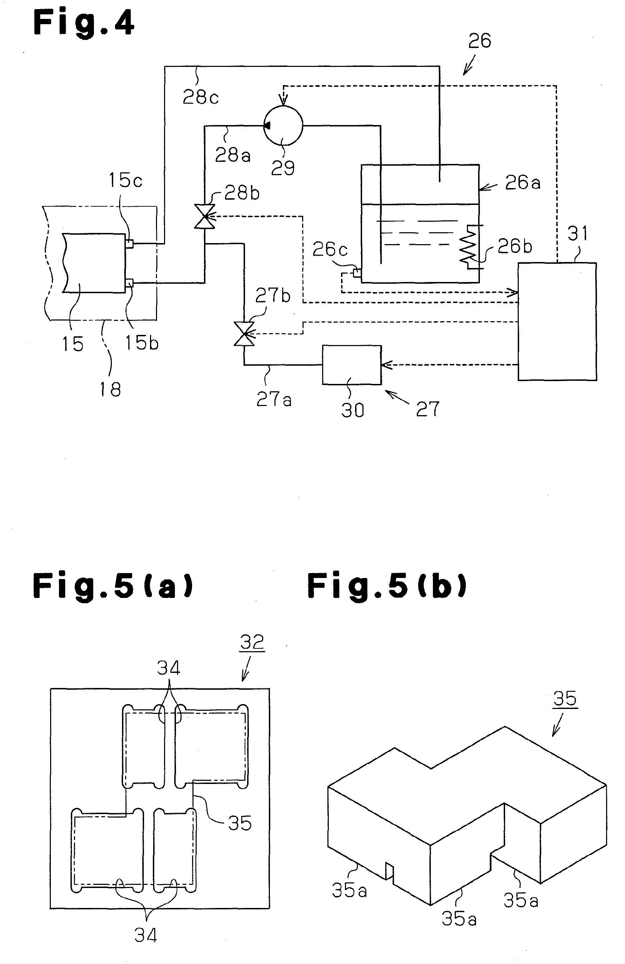

Referring to Fig. 4, the heating medium supplying unit 26 includes a heating medium heating unit 26a arranged outside the main body 18. The heating medium heating unit 26a includes a heater 26b. In a state in which the circuit board 11 is supported by the support base 20, the heating medium heating unit 26a is connected to the refrigerant passage 15a by a pipe 28a and the pipe 28c. One end of the pipe 28a is connectable to the inlet 15b of the refrigerant passage 15a, and one end of the pipe 28c is connectable to the outlet 15c of the refrigerant passage 15a. A pump 29 and a valve 28b, which is located downstream to the pump 29, are arranged in the pipe 28a. When the pump 29 is driven, a heating medium circulates through the heating medium heating unit 26a, the pipe 28a, the refrigerant passage 15a, and the pipe 28c. In this embodiment, a liquid such as polyphenylether may be used as the heating medium.

Further, a cooling medium supplying unit 27 includes a compressor 30, a pipe 27a, and a valve 27b arranged in the pipe 27a. The pipe 27a has one end connected to the compressor 30 and another end connected to the pipe 28a downstream to the valve 28b. Electromagnetic valves are used as the valves 27b and 28b.

A controller 31 controls the valves 23b, 24b, 25b, 27b, and 28b, the heater 26b, the pump 29, and the compressor 30. The controller 31 receives a detection signal of a pressure sensor (not shown), which detects the pressure in the container 17, and a detection signal of a temperature sensor 26c, which detects the temperature of a heating medium heated by the heating medium heating unit 26a. The controller 31 controls the heater 26b based on the detection signal of the temperature sensor 26c. The controller 31 functions as a control unit for controlling the temperature of the heating medium supplied to the refrigerant passage 15a.

Fig. 5(a) shows a jig 32 used for soldering. Fig. 5(b) shows a weight 35. The jig 32 is flat and has the same size as the ceramic substrates 14 of the circuit board 11. The jig 32 is formed from a material such as graphite or ceramics. As shown in Fig. 3, during soldering, the jig 32 is used to position solder sheets 33, the semiconductor elements 12, and the weight 35 on the ceramic substrate 14. The jig 32 has a plurality of positioning holes 34. The holes 34 are formed in the jig 32 at positions corresponding to portions (bonding portions) of the ceramic substrate 14 to which the semiconductor elements 12 are bonded. Each hole 34 has dimensions corresponding to the size of the corresponding semiconductor element 12. In this embodiment, a plurality of (four) semiconductor elements 12 are bonded to the ceramic substrate 14. Thus, a plurality of (four) holes 34 are formed in the jig 32.

The weight 35 is large enough to come in contact with the upper surfaces of the four semiconductor elements 12 (non-bonding surfaces) positioned by the jig 32 during soldering. The weight 35 presses the four semiconductor elements toward the circuit board 11 with its weight and spreads the melted solder between bonding surfaces of the semiconductor elements 12 and a bonding portion of the circuit board 11. The weight 35 has a side that comes into contact with the four semiconductor elements 12 during soldering and defines a pressing surface shaped in correspondence with the layout of the four semiconductor elements 12. In the present embodiment, the pressing surface of the weight 35 is divided into four pressing surfaces 35a. The pressing surfaces 35a are shaped so that they are insertable into the four holes 34 of the jig 32 in a manner enabling contact with the corresponding semiconductor elements 12. Fig. 5(a) indicates the contour of the pressing surfaces 35a of the weight 35 with a double-dashed line and shows the positional relationship between the jig 32 and the weight 35 when the weight 35 is inserted into the holes 34 of the jig 32.

A method for soldering the semiconductor elements 12 to the circuit board 11 with the soldering apparatus HK will now be described. The soldering is one of the processes that are performed when manufacturing the semiconductor module 10. Before performing soldering with the soldering apparatus HK, a plurality of (six) ceramic substrates 14, each including a metal circuit 13, are bonded to a single heat sink 15 to form an object (hereafter referred to as the "soldering subject." The soldering subject corresponds to the semiconductor module 10 shown in Fig. 1 less the semiconductor elements 12.

When performing soldering, the cover body 19 is first removed from the main body 18 to open the opening 18a. The soldering subject is then placed and positioned on the support base 20 of the main body 18. Next, a jig 32 is arranged on each ceramic substrate 14 of the soldering subject. Solder sheets 33 and semiconductor elements 12 are arranged in the holes 34 of the jig 32. In this state, the solder sheets 33, the semiconductor elements 12, and the weight 35 are arranged in an overlapping manner from the metal circuit 13 on each ceramic substrate 14. Further, in a state in which each weight 35 extends over four semiconductor elements 12, the pressing surfaces 35a of the weight 35 comes into contact with the non-bonding surfaces of the semiconductor elements 12. In this state, the weight 35 is arranged so that its weight presses the semiconductor elements 12.

Next, the cover body 19 is attached to the main body 18 to close the opening 18a and form the sealed space S in the container 17. Then, a control signal of the controller 31 operates the gas discharge unit 25 to depressurize the container 17. Further, the inert gas supply unit 24 is operated to supply nitrogen into the container 17 and fill the sealed space S with inert gas. After repeating the depressurizing and the supplying of nitrogen a few times, the reducing gas supply unit 23 is operated to supply hydrogen into the container 17 and create a reducing gas atmosphere in the sealed space S.

Then, the controller 31 controls and switches the valve 27b to a closed state and the valve 28b to an open state. Further, the controller 31 controls and drives the pump 29. As a result, the heating medium heated by the heater 26b in the heating medium heating unit 26a is supplied via the pipe 28a and the like to the refrigerant passage 15a by the action of the pump 29. The heat of the heated heating medium is transmitted to the solder sheets 33 via the heat sink 15, the ceramic substrates 14, and the metal circuits 13. The solder sheets 33 then melt as the temperature becomes greater than or equal to its melting point. The controller 31 controls the heater 26b so that the temperature of the heating medium in the heating medium heating unit 26a reaches a predetermined temperature higher than the melting point of the solder sheets 33. When the pump 29 is driven, the heating medium is heated to a temperature higher than the melting point of the solder sheets 33, and the high-temperature heating medium is supplied to the refrigerant passage 15a. The heating medium supplied to the refrigerant passage 15a returns to the heating medium heating unit 26a via the outlet 15c and the pipe 28c to be heated by the heater 26b and used repetitively.

The semiconductor elements 12 are pressed toward the circuit board 11 by the weight 35 and thus are not moved by the surface tension of the melted solder. When the solder sheets 33 completely melt, the pump 29 is deactivated and the valve 28b is closed to stop the supply of heating medium to the refrigerant passage 15a. This stops the heating of the solder. Experiments are conducted beforehand to obtain the required time for the solder sheets 33 to completely melt from when the supply of the heating medium is started. The required time is set beforehand in the controller 31. The controller 31 controls the pump 29 and the like so that the supply of the heating medium is stopped as the required time elapses from when the supply of the heating medium is started. This eliminates the need to check whether the solder sheets 33 have completely melted.

The heater 26b is controlled based on the detection result of the temperature sensor 26c arranged in the heating medium heating unit 26a. The atmosphere in the container 17, that is, the atmosphere of the sealed space S, is adjusted in accordance with the progress in the soldering operation. In other words, the pressure in the container 17 is adjusted in accordance with the progress in the soldering operation.

After stopping the supply of the heated heating medium to the refrigerant passage 15a, the valve 27b opens to supply the refrigerant passage 15a with compressed air as a cooling medium from the compressor 30. As a result, the heating medium remaining in the pipe 28a at a portion downstream from the portion connected to the pipe 27a is recovered in the heating medium heating unit 26a. The compressed air supplied to the refrigerant passage 15a cools the heat sink 15 and members arranged on the heat sink 15. The compressed air is then sent to the heating medium heating unit 26a via the outlet 15c and the pipe 28c and discharged out of a discharge port (not shown) arranged in the heating medium heating unit 26a. Consequently, the melted solder solidifies as it cools down to a temperature below the melting point and bonds the metal circuit 13 and the semiconductor elements 12. This ends the soldering operation and completes the semiconductor module 10.

After the temperature of the solder is lowered to a predetermined temperature, the valve 27b is closed to stop the supply of the cooling medium to the refrigerant passage 15a. Then, the cover body 19 is removed from the main body 18, and the weights 35 and jigs 32 are removed from the semiconductor module 10. One end of the pipe 28a is removed from the inlet 15b, and one end of the pipe 28c is removed from the outlet 15c. Then, the semiconductor module 10 is taken out of the container 17. Experiments are conducted beforehand to obtain the required time for the temperature of the solder to decrease to a predetermined temperature from when the supply of the cooling medium is started. The required time is set beforehand in the controller 31. The controller 31 controls the valve 27b and the like so that the supply of the cooling medium is stopped as the required time elapses from when the supply of the cooling medium is started. This eliminates the need to check whether the solder temperature has decreased to the predetermined temperature.

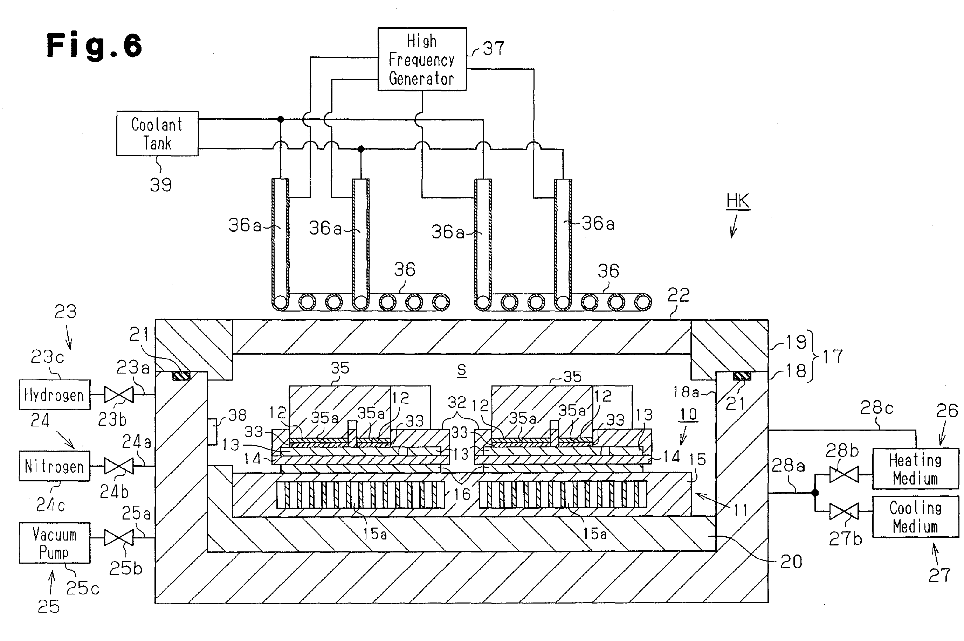

This embodiment has the advantages described below.
(1) When soldering the circuit board 11 and the semiconductor elements 12, the circuit board 11 is used as a cooling circuit board. The cooling circuit board includes the ceramic substrates 14 (insulation substrates), the front surfaces on which the metal circuits 13 are arranged, and the metal heat sink 15, which is fixed to the rear surfaces of the ceramic substrates 14. In a state in which solder is arranged between the metal circuits 13 and the semiconductor elements 12, the heated heating medium is sent into the refrigerant passage 15a to heat and melt the solder. The heat of the heating medium is transmitted to the solder via the metal heat sink 15, which has superior heat conductance. Afterwards, the heating of the solder is stopped and the melted solder is cooled to complete the soldering. Accordingly, unlike when entirely heating the container 17 or heating the semiconductor elements 12 from above with a heater, that is, unlike when transmitting heat to the solder via a gas of which heat conductance is lower than the heat sink 15 by at least a two digit value, the heat of the heating medium in the present embodiment is transmitted to the solder without passing through a gas. Thus, the solder is efficiently heated.
(2) After the heating of solder is stopped, a cooling medium is sent into the refrigerant passage 15a to cool the circuit board 11 (cooling circuit board) and the solder. That is, the refrigerant passage 15a of the heat sink 15 is used as a passage for the cooling medium and not just as a passage for the heating medium. Accordingly, the solder is efficiently cooled, and the time required to cool the semiconductor elements to a predetermined temperature is shortened.
(3) The soldering is performed in the sealable container 17. Thus, in comparison with when performing soldering in a state open to the outer side, the heat of the heating medium does not easily escape and the solder is further efficiently heated.
(4) The weight 35 is arranged on and extends over a plurality of semiconductor elements 12 that are not laid out straight. Further, the solder is heated and melted in a state in which the weight 35 presses the semiconductor elements 12 toward the circuit board 11. Accordingly, when the solder melts, the weight 35 presses the semiconductor elements 12 toward the bonding surface in a horizontal state or a generally horizontal state. Thus, the melted solder between the semiconductor elements 12 and the metal circuits 13 spreads out entirely on the surfaces of the semiconductor elements 12 facing toward the metal circuits 13. When the solder cools to a temperature that is lower than or equal to its melting point, the solder solidifies at the bonding portions with a uniform thickness.
(5) The weight 35 includes the plurality of pressing surfaces 35a respectively shaped in correspondence with the contours of the semiconductor elements 12. Further, the weight 35 presses the plurality of semiconductor elements 12 with all of the pressing surfaces 35a. Accordingly, pressing forces applied to the semiconductor elements 12 are uniformed so that differences in the solder thickness at the bonding portions are decreased.
(6) The semiconductor module 10 includes the circuit board 11, which serves as a cooling circuit board. The circuit board 11 is formed by fixing one or more ceramic substrates 14, having surfaces on which the metal circuits 13 are arranged, to the metal heat sink 15, which includes the refrigerant passage 15a. The solder spreads out entirely on the surfaces of the semiconductor elements 12 facing towards the metal circuits 13 and solidifies with a uniform thickness. Accordingly, in the semiconductor module 10, the solder functions to relax stress by absorbing differences in the coefficient of linear expansion between the semiconductor elements 12 and the metal circuits 13. This prevents variations in the fatigue life of the bonding portions.
(7) A liquid is used as the heating medium, and a gas is used as the cooling medium. Accordingly, by supplying the cooling medium to the refrigerant passage 15a, the heating medium remaining in the refrigerant passage is easily recovered in the heating medium heating unit 26a without mixing with the cooling medium.
(8) Compressed air is used as the cooling medium. This lowers costs in comparison to when other gases are used.
   A second embodiment of the present invention will now be described with reference to Fig. 6. The second embodiment differs from the first embodiment in that in addition to the heating medium supplying unit 26 that supplies the refrigerant passage 15a with a heating medium for heating the solder on the circuit board, a heating device that does not use the heat of a heating medium to heat the solder is further employed. Otherwise, the structure of the second embodiment is basically the same as the first embodiment. Similar parts will not be described in detail.
   The soldering apparatus HK includes weights 35 and high frequency heating coils 36. The weights 35 are placed on semiconductor elements 12 and formed from a material enabling induction heating. The high frequency heating coils 36 can heat the weights 35 through high frequency induction. The weights 35 and the high frequency heating coil 36 functions as a heating device. The cover body 19 includes a portion 22 facing toward the sealed space S. The portion 22 is formed from an electrical insulating material that allows passage of magnetic lines of flux (magnetic flux). In the present embodiment, glass is used as the electrical insulating material. The portion 22 of the cover body 19 is formed by a glass plate 22.
   High frequency heating coils 36 are arranged at an upper part of the soldering apparatus HK, specifically, above the cover body 19. The present embodiment includes six high frequency heating coils 36. As shown in Fig. 6, the high frequency heating coils 36 are arranged to face six ceramic substrates 14, respectively. In this embodiment, when viewed from above, each high frequency heating coil 36 is large enough to cover a single ceramic substrate 14 and larger than the contour of the upper surface of the weight 35. Each high frequency heating coil 36 is spirally wound within a single plane so as to form a substantially quadrangular plate as a whole. Each high frequency heating coil 36 is arranged to face the cover body 19, specifically to face the grass plate 22. The high frequency heating coils 36 are electrically connected to a high frequency generator 37 of the soldering apparatus HK. The output of the high frequency generator 37 is controlled based on the measurement result of a temperature sensor 38, which is arranged in the container 17. Each high frequency heating coil 36 has a coolant passage 36a, through which coolant flows. The high frequency heating coils 36 are connected to a coolant tank 39 of the soldering apparatus HK.
   The weight 35 is formed from a material that can be heated through electromagnetic induction. More specifically, the weight 35 is formed from a material that generates heat due to its electric resistance when current is generated as changes occur in the magnetic flux passing through the weight 35. In this embodiment, the weights 35 are formed from stainless steel.
   A method for soldering the semiconductor elements 12 with the soldering apparatus HK will now be described. The soldering is one of the processes that are performed when manufacturing the semiconductor module 10.
   In the same manner as in the first embodiment, when performing soldering with the soldering apparatus HK of this embodiment, the jigs 32 are placed on the ceramic substrates 14 of the soldering subject supported on the support base 20 of the main body 18. In this state, the solder sheets 33 and the semiconductor elements 12 are arranged in the holes of the jigs 32, and the weights 35 are arranged on the semiconductor elements 12.
   Then, the cover body 19 is attached to the main body 18 to close the opening 18a and form a sealed space S in the container 17. In a state in which the circuit board 11, the solder sheets 33, the semiconductor elements 12, and the weights 35 are accommodated in the sealed space S, the high frequency heating coils 36 are arranged above the corresponding weights 35. The glass plate 22, which is attached to the cover body 19, is located between the high frequency heating coils 36 and the weights 35. In this embodiment, each high frequency heating coil 36 is formed and arranged so that when viewed from above, the high frequency heating coil 36 extends out of a region defined by the contour of the upper surface of the weight 35. In this embodiment, a large amount of magnetic flux is generated near the central part of the high frequency heating coil 36, which is spirally wound. Thus, it is preferable that the weight 35 be arranged near the central part of the high frequency heating coil 36.
   Then, a control signal of the controller 31 operates the gas discharge unit 25 to depressurize the container 17. Further, the inert gas supply unit 24 is operated to supply nitrogen into the container 17 and fill the sealed space S with inert gas. After repeating the depressurizing and the supplying of nitrogen a few times, the reducing gas supply unit 23 is operated to supply hydrogen into the container 17 and create a reducing gas atmosphere in the sealed space S.
   Next, in the same manner as in the first embodiment, the controller 31 controls and switches the valve 27b to a closed state and the valve 28b to an open state. Further, the pump 29 is driven so that the heating medium heated by the heater 26b in the heating medium heating unit 26a is supplied via the pipe 28a and the like to the refrigerant passage 15a by the action of the pump 29. The heat of the heated heating medium is transmitted to the solder sheets 33 via the heat sink 15, the ceramic substrates 14, and the metal circuits 13.
   Then, the high frequency generator 37 is operated to generate high frequency current that flows to each high frequency heating coil 36. As a result, the high frequency heating coil 36 generates high frequency magnetic flux, which passes through the corresponding weight 35. The passage of the magnetic flux generates eddy current in the weight 35. As a result, the weight 35, which is arranged in the magnetic flux of the high frequency heating coil 36, generates heat through electromagnetic induction. The heat is transmitted from the pressing surfaces 35a of the weight 35 to the corresponding semiconductor elements 12. The heat generated in the weight 35 is transmitted to the solder sheets 33 in a concentrated manner through the pressing surfaces 35a of the weight 35 and the semiconductor elements 12. This heats the solder sheets 33.
   As a result, the heat of the heating medium flowing through the refrigerant passage 15a and the heat generated at the weights 35 through induction heating by the high frequency heating coils 36 both heat the solder (solder sheets 33). This heats the solder from both of the upper and lower sides. Thus, the heating is more quickly and efficiently performed.
   When the solder sheets 33 completely melt, the pump 29 is deactivated and the valve 28b is closed to stop the supply of heating medium to the refrigerant passage 15a. Further, the high frequency generator 37 is deactivated to stop heating the solder. Experiments are conducted beforehand to obtain the required time for the solder sheets 33 to completely melt from when the supply of the heating medium is started and when the supply of high frequency current to the high frequency heating coils 36 is started. The required time is set beforehand in the controller 31. The controller 31 controls the pump 29, the high frequency heating coils 36, and the like so that the supply of the heating medium and the supply of the high frequency current is stopped as the required time elapses from when the supply of the heating medium and the high frequency current is started. This eliminates the need to check whether the solder sheets 33 have completely melted.
   In the same manner as in the first embodiment, compressed air as a cooling medium is then supplied to the refrigerant passage 15a. Further, the controller 31 controls the valve 27b and the like to stop supplying the cooling medium when a predetermined time, which is set beforehand, elapses from when the supply of the cooling medium is started.
   In addition to advantages (1) to (8) of the first embodiment, this embodiment has the advantages described below.
(9) The solder (solder sheet 33) is heated by the heat of the heated heating medium flowing through the refrigerant passage 15a and the heat of the further heating device. This heats the solder within a shorter period of time.
(10) The further heating device generates heat by performing high frequency induction with the weights 35, which are placed on the semiconductor elements 12 and formed from a material enabling induction heating. The heat is transmitted from the weights 35 via the semiconductor elements 12 to the solder. Accordingly, in comparison with a heater (electric heater) used in a typical reflow furnace, heat is transmitted in a concentrated manner to the solder. Thus, the solder is efficiently heated. More specifically, the heating medium supplied to the refrigerant passage 15a uniformly heats the entire heat sink 15. Further, the weights 35 heated by induction heating locally heats vicinity of the solder. As a result, the advantages of the two heating schemes are combined thereby enabling satisfactory temperature control.
(11) The heated heating medium and the further heating device heat the solder. Thus, the solder can be melted without heating the heating medium to a temperature that is higher than the melting point of the solder. In other words, the heated heating medium heats the solder in a supplemental manner, while the further heating device heats the solder to a temperature that is higher than the melting point. This increases freedom in the selection of the material used as the heating medium.
(12) When performing soldering on the circuit board 11, which includes the plurality of ceramic substrates 14, one high frequency heating coil 36 is arranged on each ceramic substrate 14 (weight 35), and the weight 35 on the ceramic substrate 14 is heated. This increases efficiency in comparison with when one high frequency heating coil 36 heats a plurality of the weights 35, which are respectively arranged on the ceramic substrates 14.
(13) The high frequency heating coils 36 is arranged outside the container 17 and not inside the container 17. This enables the volume of the container 17 to be minimized and enables the container 17 to be reduced in size. Further, the atmosphere adjustment mainly includes the discharge of air from the container 17 (depressurization), the supply and discharge of inert gas (nitrogen gas etc.), and the supply and discharge of reducing gas (hydrogen etc.). Thus, reduction in the volume of the container 17 would, for example, shorten the time required for discharging air and decreases the consumption of energy required for discharging air (e.g., the energy required to operate the vacuum pump 25c). Further, the time required for supplying or discharging inert gas or reducing gas may be shortened, the energy required for supplying or discharging inert gas or reducing gas may be decreased, and the consumption of the supplied gas may be lowered.

The embodiments are not limited to those described above and may be modified as described below.

The heating medium supplied to the refrigerant passage 15a may be a gas. For example, hydrogen gas, nitrogen gas, or the like may be used as the gas. When using a gas as the heating medium, it is preferable that hydrogen gas be used since it has a larger heat conductance and larger specific heat than other gases. The heating medium and the cooling medium may both be hydrogen gas. However, this would increase the amount of the used hydrogen gas. Thus, the use of a gas other than hydrogen gas as the cooling medium, for example, nitrogen gas, would lower costs.

When using a gas as the heating medium, the heat generated when the heating medium is compressed by a compressor and the heat generated when the heater heats the heating medium may both be used. In this case, the compressor functions as the pump 29.

The liquid heating medium is not limited to polyphenylether. For example, LLC (long-life coolant) may be used as the heating medium. In this case, it is difficult to heat the heating medium to a temperature higher than the melting point of the solder. Thus, it is preferred that the structure of the second embodiment be employed since a further heating device is used.

A liquid may be used as the cooling medium.

When using a cooling medium, a heat exchanger may be arranged in the pipe 27a, and a cooling medium cooled by the heat exchanger may be supplied to the refrigerant passage 15a. This enables the solder to be cooled within a shorter time. Further, a cooling medium that is not cooled may be initially supplied to the refrigerant passage 15a, and then the cooled cooling medium may be supplied to the refrigerant passage 15a.

The further heating device is not limited to a structure including the weights 35, which can undergo induction heating, and the high frequency heating coils 36. For example, an electric heater for heating the solder or a device for emitting a laser beam may be arranged in the container 17.

The electronic components soldered to the metal circuit 13 of the circuit board 11 are not limited to the semiconductor elements 12. For example, the electronic components may be chip resistors or chip capacitors.

The weights 35 do not all have to be of the same size and shape. For example, the plurality of semiconductor elements 12 may be divided into a plurality of groups, and the weights 35 may be shaped in correspondence with the layout of the semiconductor elements 12 in each group.

The pressing surfaces 35a of each weight 35 does not need to have a size enabling contact with the entire non-bonding surfaces of the corresponding semiconductor elements 12 and may be larger or smaller.

The jig 32 is not limited to a structure that functions to position the solder sheets 33, the semiconductor elements 12, and the weights 35 and may have a structure that functions to position only the solder sheets 33 and the semiconductor elements 12.

In a structure in which the solder is melted with the heat generated by the weights 35 through induction heating, the weights 35 do not have to be formed from stainless steel. The weights 35 may be formed from any material suitable for induction heating. For example, the weights 35 may be formed from iron or graphite instead of stainless steel or may be formed from two conductive materials having different thermal conductivity coefficients.

Instead of arranging the solder sheets 33 at locations corresponding to bonding portions on the metal circuit 13, a solder paste may be applied at the locations corresponding to the bonding portions.

The cover body 19 may be configured so as not detachable to the main body 18 and may be connected to the main body 18 so that the cover body 19 can open and close the main body 18.

It is preferable that at least a portion of the cover body 19 facing toward the high frequency heating coils 28 be formed from an electrically insulative material. Instead of glass, this portion may be formed from ceramics or a resin. Further, the cover body 19 may entirely be formed from the same electrically insulative material.

When the strength of the cover body 19 must be increased in accordance with the pressure difference between the inside and outside of the container 17, the cover body 19 may be formed from a complex material (GFRP (glass fiber reinforced plastics)) of glass fiber and resin. Further, the cover body 19 may be formed from metal. The metal is preferably a non-magnetic metal. If magnetic metal is used as the material for the cover body 19, it is preferred that a metal having a higher electrical resistivity than the weight 35 be used. The cover body 19 may be formed from complex material of metal and an insulative material. An electromagnetic steel plate etc. of ferromagnetic body may be used immediately above the weight 35 to effectively guide magnetic flux to the weight 35.

Each high frequency heating coil 36 may be arranged above the plurality of weights 35 so as to extend over the plurality of weights 35. In this case, the supply path of the high frequency current and the supply path of the cooling water to the high frequency heating coil 36 may be shortened, and the structure of the soldering device HK may be further simplified.

The container 17 may be movable along a production line, and the high frequency heating coil 36 may be arranged along the movement path of the weights 35, which move together with the container 17. In this case, the high frequency heating coil 36 may be shaped to extend along the movement path or may be arranged at plural locations along the movement path. In such a structure, the container 17 can be heated as it moves.

The high frequency heating coils 36 may be arranged so as to face toward the side surfaces of the weights 35.

The high frequency heating coils 28 may be arranged in the container 17 (sealed space S).

During soldering, instead of pressing the semiconductor elements 12 with the weight of the weights 35, a biasing member such as a spring may be used to press the semiconductor elements 12.

The components soldered to the circuit board 11 is not limited to chip components and may be lead components including leads.

Soldering does not have to be performed in the sealable container 17. For example, soldering may be performed in a container having a loading port, through which the circuit board 11 is loaded in a state placed on a conveying device such as a belt conveyor, and an unloading port, from which the circuit board 11 is unloaded. Further, soldering may be performed without the container. That is, soldering may be performed in a state where no enclosing member, which encloses the location of the soldering, is provided.

When soldering electronic components onto the circuit board 11, which includes the heat sink 15, the solder may be heated by the further heating device without supplying a heating medium to the refrigerant passage 15a, and the heat sink 15 may be used only for cooling.

## Claims

1. A soldering method for soldering an electronic component onto a circuit board, the method comprising:
using as the circuit board a cooling circuit board including an insulation substrate and a metal heat sink, the insulation substrate having a front surface with a metal circuit and a rear surface to which the heat sink is fixed, and the heat sink having a refrigerant passage;
arranging the electronic component on the metal circuit with solder in between; and
supplying a heated heating medium to the refrigerant passage when heating and melting the solder.

2. The soldering method according to claim 1, further comprising:
supplying a cooling medium to the refrigerant passage to cool the cooling circuit board and the solder after stopping the heating of the solder.

3. The soldering method according to claim 2, further comprising:
using a liquid as the heating medium; and
using a gas as the cooling medium.

4. The soldering method according to any one of claims 1 to 3, further comprising:
retaining the cooling circuit board in a sealable container; and
heating the solder with a heating device while supplying the refrigerant passage with the heated heating medium to melt the solder in a state in which the cooling circuit board is retained in the container.

5. The heating method according to claim 4, wherein said heating the solder with a heating device includes performing high frequency induction to generate heat with a weight formed from a material enabling induction heating and placed on the electronic component, and transmitting the heat of the weight to the solder through the electronic component.

6. The soldering method according to any one of claims 1 to 5, further comprising:
using a heat sink made of aluminum or copper.

7. A soldering method for soldering an electronic component onto a circuit board, the method comprising:
using as the circuit board a cooling circuit board including an insulation substrate and a metal heat sink, the insulation substrate having a front surface with a metal circuit and a rear surface to which the heat sink is fixed, and the heat sink having a refrigerant passage;
arranging the electronic component on the metal circuit with solder in between;
heating and melting the solder; and
supplying a cooling medium to the refrigerant passage to cool the cooling circuit board and solder after stopping the heating of the solder.

8. A method for manufacturing a semiconductor module formed by soldering an electronic component onto a circuit board, the method comprising:
using as the circuit board a cooling circuit board including an insulation substrate and a metal heat sink, the insulation substrate having a front surface with a metal circuit and a rear surface to which the heat sink is fixed, and the heat sink having a refrigerant passage;
arranging the electronic component on the metal circuit with solder in between; and
supplying a heated heating medium to the refrigerant passage when heating and melting the solder.

9. The manufacturing method according to claim 8, further comprising:
supplying a cooling medium to the refrigerant passage to cool the cooling circuit board and the solder after stopping the heating of the solder.

10. The manufacturing method according to claim 9, further comprising:
using a liquid as the heating medium; and
using a gas as the cooling medium.

11. The manufacturing method according to any one of claims 8 to 10, further comprising:
retaining the cooling circuit board in a sealable container; and
heating the solder with a heating device while supplying the refrigerant passage with the heated heating medium to melt the solder in a state in which the cooling circuit board is retained in the container.

12. The manufacturing method according to claim 11, wherein said heating the solder with a heating device includes performing high frequency induction to generate heat with a weight formed from a material enabling induction heating and placed on the electronic component, and transmitting the heat of the weight to the solder through the electronic component.

13. The manufacturing method according to any one of claims 8 to 12, further comprising:
using a heat sink made of aluminum or copper.

14. A method for manufacturing a semiconductor module formed by soldering an electronic component onto a circuit board, the method comprising:
using as the circuit board a cooling circuit board including an insulation substrate and a metal heat sink, the insulation substrate having a front surface with a metal circuit and a rear surface to which the heat sink is fixed, and the heat sink having a refrigerant passage;
arranging the electronic component on the metal circuit with solder in between;
heating and melting the solder; and
supplying a cooling medium to the refrigerant passage to cool the cooling circuit board and solder after stopping the heating of the solder.

15. A soldering apparatus for soldering an electronic component onto a circuit board, the soldering apparatus comprising:
a support capable of supporting the circuit board, wherein the circuit board is a cooling circuit board including an insulation substrate and a metal heat sink, the insulation substrate having a front surface with a metal circuit and a rear surface to which the heat sink is fixed, and the heat sink having a refrigerant passage, with the refrigerant passage including an inlet and an outlet;
a heating medium supply unit capable of supplying a heating medium to the refrigerant passage, with the heating medium supply unit including a pipe connectable to the inlet and the outlet in a state in which the cooling circuit board is supported by the support; and
a control unit for controlling temperature of the heating medium supplied to the refrigerant passage.

16. The soldering apparatus according to claim 15, further comprising:
a sealable container for retaining the cooling circuit board, with the support being arranged in the container.

17. The soldering apparatus according to claim 15 or 16, further comprising:
a heating device capable of heating solder on the cooling circuit board supported by the support.

18. The soldering apparatus according to claim 17, wherein the heating device includes a weight formed from a material enabling induction heating and placeable on the electronic component, and a high frequency heating coil capable of generating heat with the weight through high frequency induction.

19. The soldering apparatus according to any one of claims 15 to 18, further comprising:
a cooling medium supply unit capable of supplying a cooling medium to the refrigerant passage in a state in which the cooling circuit board is supported by the support.

20. The soldering apparatus according to claim 19, wherein the heating medium is a liquid, and the cooling medium is a gas.

21. The soldering apparatus according to any one of claims 15 to 20, wherein the heat sink is made of aluminum or copper.
